# EUROPEAN PATENT APPLICATION

(11) **EP 2 040 310 A2**
(43) Date of publication of application: **25.03.2009**
(21) Application number: 08100137.2
(22) Date of filing: 07.01.2008
(51) Int. Cl.: H01L 31/18, H01L 31/0352, H01L 31/036, H01L 31/075

(54) **Solar cell manufactured using amorphous and nanocrystalline silicon composite thin film, and process for manufacturing the same**

(30) Priority: 18.09.2007 KR 20070094787
(71) Applicant: LG Electronics Inc., Yeongdeungpo-gu Seoul 150-721 (KR)
(72) Inventor: Choi, Yong Woo, LG ELECTRONICS INC., 137-724, Seoul (KR); Choe, Young Ho, LG ELECTRONICS INC., 137-724, Seoul (KR); Kim, Hyung Seok, LG ELECTRONICS INC., 137-724, Seoul (KR); Lee, Young Hee, LG ELECTRONICS INC., 137-724, Seoul (KR)
(74) Representative: Cabinet Plasseraud

(57) **Abstract**

Disclosed are a solar cell manufactured using a composite thin film comprising amorphous silicon and nanocrystalline silicon, a method of manufacturing the solar cell, and a composition for the composite thin film used in manufacturing the solar cell.

The solar cell of the present invention is manufactured by dispersing the crystalline silicon nanoparticles in the liquid silicon precursor, coating the dispersion on a substrate or printing the substrate with the dispersion, and heating the coated or printed substrate to modify the liquid silicon precursor into the amorphous silicon.

According to the present invention, expensive equipments are not needed to form a composite thin film comprising both of amorphous silicon and crystalline silicon. In addition, it is possible to form a composite thin film comprising plural materials with different band gap energy which can remarkably improve conversion efficiency of a solar cell by using a liquid precursor and nanocrystalline particles in a solution process with low production cost.

## Description

### BACKGROUND OF THE INVENTION

This application claims priority to Korean Patent Application No. 2006-00000, filed on October 00, 2006, in the Korean Intellectual Property Office, the entire contents of which are hereby incorporated by reference.

### 1. Field of the Invention

The present invention relates to solar cells manufactured by using amorphous silicon and nanocrystalline silicon based composite thin films and manufacturing processes thereof, more particularly, to a method of manufacturing solar cells with silicon semiconductor films formed of composite thin films comprising amorphous silicon and nanocrystalline silicon, each of the composite thin films being formed with low production cost using a liquid silicon precursor and silicon nanoparticles.

### 2. Description of the Related Art

Increase in conversion efficiency is very important in solar cell fields. Using together two or more of materials having different optical band-gaps can improve application efficiency of a broader range of light sources and raise the conversion efficiency.

Silicon has variable band-gaps based on condition of crystals. Amorphous silicon and crystalline silicon have a band-gap of 1.7eV and 1.1eV, respectively.

In order to increase the conversion efficiency of the solar cell, a tandem cell structure has been proposed in the related arts, which is fabricated by laminating an amorphous silicon layer and a crystalline silicon layer into a double-layered solar cell film.

Such a solar cell in which the amorphous silicon coexists with the crystalline silicon is expected to improve the conversion efficiency of the solar cell.

However, a solar cell with a lamination structure comprising multiple silicon layers with different particle phases, has a few problems such as complicated and longer processes, restriction of current generated from light by one of the solar cell layers having the least current, due to the structure of the solar cell being in a series connection form, etc. Therefore, the above solar cell has a difficulty in accomplishing the higher conversion efficiency unless photoelectric currents generated from the solar cell layers are designed to be identical.

Formation of a silicon film on the solar cell is mostly executed by, for example, chemical vapor deposition (CVD) processes of mono-silane or di-silane gases.

However, the formation of silicon film using CVD normally adopts a gas-phase reaction and, in turn, the reaction is carried out on walls of a reaction chamber or in a gas phase thereby generating contaminants or impurities which lead to decrease in production yield. Furthermore, the CVD has a low reaction velocity thereby further reducing productivity. The CVD also includes a drawback of requiring complicated and expensive installations because it uses specific apparatuses such as vacuum equipment and a high frequency generator. For raw materials used in the CVD, gaseous silane with high toxicity and reactivity is used, which is difficult to be managed and/or handled and needs more expensive equipment for management or maintenance thereof.

Meanwhile, carrier lifetime of the solar cell which plays an important role in the conversion efficiency of the solar cell is affected by defects existing in the composite thin film. The defects promote recombination of the carrier and reduce the carrier lifetime, thereby decreasing the conversion efficiency of the solar cell.

Accordingly, there is a requirement for simpler, more convenient and economical processes and/or installations to produce solar cells with improved conversion efficiency and reduction of defects on an interface between amorphous silicon and crystalline silicon, which comprises the amorphous silicon and the crystalline silicon coexisting therein.

### SUMMARY OF THE INVENTION

Accordingly, the present invention is directed to solve the problems of conventional methods as described above and, an object of the present invention is to provide a composite thin film for a solar cell formed by a solution process such as coating, printing, etc. that does not need vacuum conditions or alternative complicated equipment.

Another object of the present invention is to provide a solar cell with enhanced photoelectric conversion efficiency and reduced defects, manufactured by fabricating a composite thin film with amorphous silicon and crystalline silicon which are usually used in conventional solar cells.

A further object of the present invention is to provide a composition for a composite thin film used in a solar cell that has a high efficiency semiconductor film, comprising amorphous silicon as a liquid silicon precursor and nanocrystalline silicon.

A still further object of the present invention is to considerably reduce production costs of manufacturing a solar cell by adopting a simpler process, more convenient and economical apparatus without requiring any complicated processes and/or more expensive equipment.

In order to accomplish the above objects, the inventive solar cell comprises at least one composite thin film including a combination of amorphous silicon and crystalline silicon. That is, each of the composite thin films includes the combination of amorphous silicon and crystalline silicon.

The composite thin film contains the amorphous silicon as a matrix and crystalline silicon particles dispersed in the matrix.

In order to accomplish the above objects, the inventive solar cell comprises at least one photoelectric conversion layer between a rear electrode and a front electrode, which includes a composite thin film comprising a matrix consisting of amorphous silicon matrix and crystalline silicon particles dispersed in the matrix.

Such solar cell having the photoelectric conversion layer according to the present invention has a structure in that the photoelectric conversion layer consists of at least one composite thin film comprising the amorphous silicon matrix and the crystalline silicon particles dispersed therein and is arranged on a substrate, and an electrode layer is formed over the photoelectric conversion layer.

The composite thin film of the solar cell according to the present invention may include the crystalline silicon particles with a particle size in the range of nano units (hereinafter referred to "nanoparticle").

The nanoparticle has preferably the particle size, for example, ranging from 1nm to 500nm without particular limitation thereto.

The amorphous silicon contained in the solar cell according to the present invention is preferably the one modified from a liquid silicon precursor.

The silicon precursor is typically defined as a precursor changeable into the amorphous silicon through physical, chemical and/or mechanical variation(s). Material condition of the silicon precursor is any one of solid, liquid and gaseous phases without particular limitation thereto, however, the liquid phase silicon precursor is preferably used in views of ensuring stability and convenient production thereof.

The liquid silicon precursor may comprise silane based compounds.

Especially, at least one selected from a group consisting of silane SiH₄, disilane Si₂H₆, cyclopentasilane Si₅H₁₀ and cyclohexasilane Si₆H₁₂. is preferably used.

The composite thin film used in the solar cell according to the present invention may further include a dispersant. Amount of the dispersant is not particularly limited but, appropriately defined to sufficiently disperse nanocrystalline silicon particles in a matrix made of the liquid silicon precursor. Preferably, the amount of the dispersant ranges from 0 to 10% in terms of content of dispersant residue in the composite thin film.

In order to accomplish the above objects, the composition for fabricating the composite thin film of the solar cell according to the present invention comprises the liquid silicon precursor and the crystalline silicon dispersed in the matrix.

Amounts of constitutional ingredients in the composition are not particularly limited, but, the liquid silicon precursor preferably ranges from 10 to 90% by weight (abbreviated to "wt.%") while the crystalline silicon preferably ranges from 10 to 90wt.% of total weight of the composition.

As mentioned above, the liquid silicon precursor may comprise the silane based compound.

Especially, at least one selected from a group consisting of silane SiH₄, disilane Si₂H₆, cyclopentasilane Si₅H₁₀ and cyclohexasilane Si₆H₁₂. is preferably used.

The composition for the composite thin film used in the solar cell may further include the dispersant with an amount of 0 to 10% in terms of content of the dispersant residue in the composition. Additionally, the composition may include a surfactant.

Similar to the composite thin film, the crystalline silicon particles dispersed in the liquid silicon precursor contained in the composition may be also the silicon nanoparticles with the particle size ranging from 1nm to 500nm.

In order to accomplish the above objects, the process for manufacturing the solar cell according to the present invention comprises the steps of: mixing the liquid silicon precursor with the crystalline silicon; coating the mixture to a substrate or an electrode layer or printing the substrate or the electrode layer with the mixture; and heat treating the coated or printed substrate or electrode layer to modify the liquid silicon precursor into an amorphous silicon matrix.

The crystalline silicon is preferably nanocrystalline silicon particles with the particle size of 1nm to 500nm.

The liquid silicon precursor is as described above.

After the heating step, the present inventive process may further comprise a passivation step to eliminate or remove defects generated in an interface between the amorphous silicon and the crystalline silicon.

Any passivation gas normally used in conventional passivation processes is applicable in the above passivation step, but, is preferably at least one selected from a group consisting of: oxygen, ozone containing oxygen, oxygen plasma gases or mixture of all of them; hydrogen gas; hydrogen fluoride; hydrogen bromide; and phosphine.

The mixture applied or used in the printing process may further include the dispersant and/or the surfactant.

Temperature for the heating is not particularly limited, but, preferably ranges from 300 to 500°C.

With regard to fabrication of the composite thin film with the photoelectric conversion layer, the present invention is characterized by using the solution process such as the coating or the printing process to form the composite thin film without requiring alternative vacuum conditions or complicated equipment.

The solution process has an advantage that phases or compositional ratios of constitutional materials in the composite thin film can be controlled without considerable alteration in condition of particles, compared with general vacuum deposition processes.

For the vacuum deposition process, as the composite thin film grows in a cone type according to progress of the film growth from seeds as a raw material, the above process has problems in that the photoelectric conversion efficiency is varied by shapes and/or sizes of silicon crystals and a relative ratio of the crystalline portion and the amorphous portion in the composite thin film is unable to be expected and controlled.

However, the formation of the photoelectric conversion layer by fabricating the composite thin film by means of the solution process according to the present invention is expected not to cause deformation of the raw material and, in turn, to keep the original form thereof as the process proceeds. As a result, the relative ratio of the crystalline portion and the amorphous portion in the composite thin film can be controlled beforehand, thereby possibly regulating and improving the photoelectric conversion efficiency in relation to the controlled relative ratio of the crystalline portion and the amorphous portion.

For the fabrication of the composite thin film by dispersing the crystalline silicon, especially, silicon nanoparticles in the amorphous silicon matrix according to the present invention, the raw material of the crystalline silicon does not undergo the shape deformation but is uniformly dispersed in the matrix to completely produce the composite thin film.

In other words, the present invention is characterized in that a liquid silane composition is changeable into the amorphous silicon by dispersing the crystalline silicon nanoparticles in the liquid silicon precursor, coating the dispersion on the substrate or printing the substrate with the dispersion, and heat treating the coated or printed substrate. By these steps, the amorphous silicon as a matrix functions to fabricate the composite thin film without variation in shapes and/or sizes of the crystalline silicon dispersed in the matrix.

The silicon composite thin film fabricated in the present invention is subjected to a passivation process to reduce defects existing in the interface between the amorphous silicon and the crystalline silicon.

A passivation gas used in the passivation process is not particularly limited, but, is preferably, oxygen gas, which endows stronger binding force than that in case of using hydrogen gas as the passivation gas, and therefore, exhibits more preferable stability.

The composite thin film passivated by the hydrogen gas shows inferior stability and has a problem of deterioration of inherent properties of the film as the time of using the film passes.

By the above process, it will be understood that the defects are passivated and the solar cell has the improved conversion efficiency. The defects are mostly caused by dangling bonds and can be passivated by combining hydrogen or oxygen with the dangling bonds.

As described above, the present invention does not need any expensive installation requiring alternative complicated equipment and can fabricate the composite thin film as a layer comprising the amorphous silicon and the crystalline silicon.

That is, the present invention can fabricate the composite thin film comprising specific materials with different band-gaps sufficient to endow excellent conversion efficiency to a solar cell by using the liquid silicon precursor and the crystalline particles, especially, nanocrystalline silicon particles by means of the solution process with low production cost.

In addition, the present invention can manufacture the solar cell with improved photoelectric conversion efficiency, which includes a plurality of composite thin films and consists of the specific materials with different band-gap energies.

According to the present invention, the composition for the composite thin film contained in the solar cell is provided, which comprises the amorphous silicon precursor and the nanocrystalline silicon. Using the composition can allow manufacture of the solar cell having the composite thin film with high efficiencies by adopting simple and convenient processes and low price economical equipment, so that the present invention has an economic advantage in view of the production cost.

### BRIEF DESCRIPTION OF THE DRAWINGS

These and other objects, features, aspects, and advantages of preferred embodiments of the present invention will be more fully described in the following detailed description, taken in conjunction with the accompanying drawings. In the drawings:
Fig. 1 and Fig. 2 are schematic diagrams illustrating a process for mixing the liquid silane composition and the nanocrystalline silicon according to one embodiment of the present invention;
Fig. 3 is a schematic diagram illustrating a process for coating the mixture of the liquid silane composition and the nanocrystalline silicon to the surface of a substrate according to one embodiment of the present invention;
Fig. 4 is a schematic diagram illustrating a modification process of the liquid silane composition which was applied to the surface of the substrate according to one embodiment of the present invention to be modified into the amorphous silicon; and
Fig. 5 is a cross-sectional view illustrating a solar cell having a composite thin film fabricated by the amorphous silicon and the nanocrystalline silicon according to one embodiment of the present invention.

### DETAILED DESCRIPTION OF THE INVENTION

Hereafter, the present invention will be described in detail in the following example with reference to the accompanying drawings.

General constructions and functions commonly known in related arts are not essential components for the present invention and have not been described in detail herein, in order to avoid unnecessary duplication of explanation thereof.

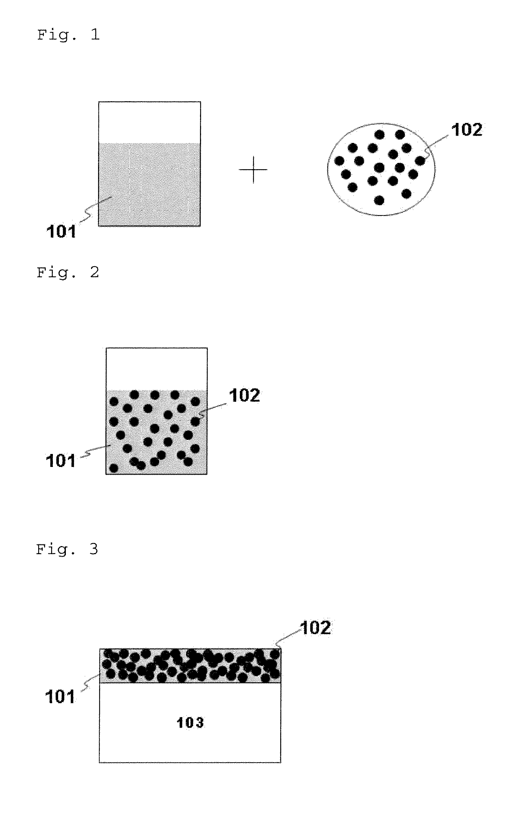

Figs. 1 and 2 illustrate a process of preparing a mixture of the liquid silicon precursor and the crystalline silicon nanoparticles according to one embodiment of the present invention.

The liquid silicon precursor may be a liquid silane SiH₄ composition 101.

The liquid silane composition can optionally include an organic solvent.

The silane composition 101 may include a colloidal silicon dispersed in an appropriate dispersing solvent. Such colloidal silicon is used for increasing silicon concentration of the silane composition 101 and can regulate thickness of a coating film by silicon content of in the composition.

In case of using the colloidal silicon, a dispersant is preferably selected and used in consideration of compatibility with silane compounds regularly used and the organic solvent optionally added in the composition. Such dispersant may include compounds illustrated as the solvent optionally added according to the present invention.

The organic solvent is not limited to particular materials, but, includes hydrocarbons having 1 to 20 carbon atoms, which comprise aliphatic hydrocarbons and aromatic hydrocarbons.

The silane composition 101 is preferably combined with microfine metal oxide powders such as aluminum oxide, zirconium oxide, titanium oxide, etc. in order to prevent gellation of the composition, increase viscosity of the composition and enhance thermal resistance, chemical resistance, hardness, close adhesiveness and/or static protection of a silicon oxide film which is fabricated using the composition.

Detailed constructions of the silane composition 101 have been disclosed and are well known to those skilled in the art, thereby eliminating need for description thereof in order not to unnecessarily obscure the present invention.

The crystalline silicon nanoparticles 102 are prepared in a nano powder form of monocrystal silicon and polycrystal silicon as general crystalline silicon materials, and preferably have a particle size ranging from 1nm to 500nm.

Fig. 3 shows a process for coating the mixture on the surface of a substrate according to one embodiment of the present invention.

The silane composition 101 is applied to the substrate to form a film having a thickness preferably ranging from 0.005 to 10 µm and, more preferably, ranging from 0.01 to 5 µm by means of appropriate methods including, for example, spray coating, roll coating, curtain coating, spin coating, screen printing, off-set printing, ink-jet method, etc.

When the composition contains the solvent, the film thickness is defined as a thickness of the film after removing the solvent from the composition.

The process for fabricating a silicon film is conducted under a non-oxidation atmosphere, which comprises the atmosphere substantially not containing oxidation materials such as oxygen, carbon dioxide, etc. and, more preferably, the atmosphere containing any one selected from nitrogen, hydrogen, rare gases and/or combination gases thereof.

Since the coating film comprising the composition of the present invention is closely and compactly formed on the substrate, the coating film is preferably subjected to light irradiation at least one time before and/or after the application.

The light irradiation uses a light source which is selected from: visible light, ultraviolet (UV), far-UV, low pressure or high pressure mercury lamps, deuterium lamp and/or streamer of rare gas such as argon Ar, krypton Kr, xenon Xe or so on; and, additionally, YAG laser; argon laser; carbon dioxide laser; excimer laser such as XeF, XeCl, XeBr, KrF, KrCl, ArF or ArCl. Such light source is preferably one with an output power of 10 to 5,000W. More preferably, the output power ranges from 100 to 1,000W. The light source has a wavelength of preferably 170 to 600nm but is not limited thereto, so far as a polysilane compound contained in the composition or the coating film can absorb the light even a little at the wavelength. Temperature for the light irradiation is preferably in the range of room temperature to 300°C. The light irradiation period ranges from 0.1 to 30 minutes. The light irradiation is preferably performed under a non-oxidation atmosphere, the same as the film fabrication process using the polysilane compound.

By the light irradiation, there is generated dissociation and re-combination of silicon-silicon bonds in the polysilane compound contained in the coating film, therefore, it is expected to improve physical properties of the film such as adhesiveness to the substrate. Also, it will be understood that the silane compound in the coating film undergoes ring-opening polymerization to produce polysilane and, in turn, fabricate a closer and more compact film.

The coating film fabricated as described above is converted into a silicon film or silicon oxide film by thermal and/or light treatment under an appropriate atmosphere. Such treatment preferably comprises a thermal treatment process.

In order to fabricate the silicon film, the coating film containing the above prepared composition of the present invention undergoes the heating preferably at 100 to 1,000°C, more preferably, 200 to 850°C and, most preferably, 300 to 500°C under a non-oxidation atmosphere and, preferably, argon gas atmosphere or hydrogen-containing argon gas.

Generally, the amorphous silicon film can be obtained at the final temperature of about 550°C or less while the polycrystal silicon film can be obtained at the temperature more than 550°C. If the final temperature is less than 300°C, thermal decomposition of the polysilane compound is insufficient and may fail to fabricate the silicon film with a desired thickness.

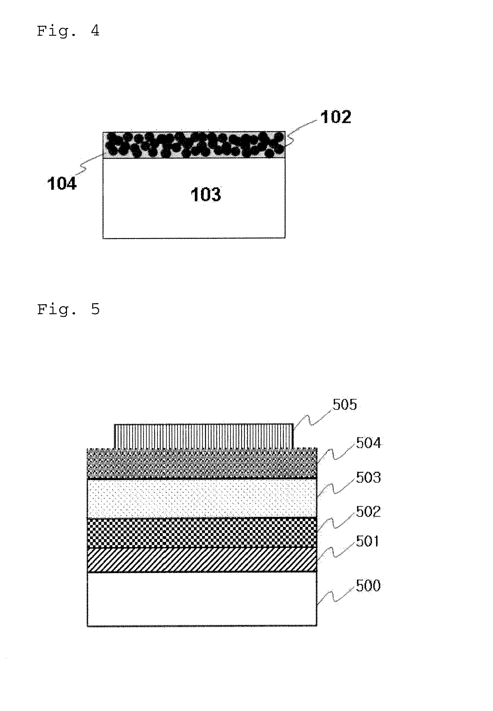

Fig. 4 is a schematic diagram to show a modification process of the liquid silane composition which was applied to the surface of the substrate according to one embodiment of the present invention to be modified into the amorphous silicon.

Since the composite thin film of the present invention includes the crystalline silicon nanoparticles dispersed in an amorphous silicon based medium, the liquid silicon precursor is heat treated to be converted into the amorphous silicon medium preferably at 300 to 500°C.

In order to produce the polycrystal type silicon film, the amorphous silicon film may undergo laser irradiation to be converted into the polycrystal silicon film.

With regard to atmosphere for the laser irradiation, inert gas such as helium, argon, etc. or a mixture of the inert gas and a reductive gas such as hydrogen is preferably used in the atmosphere for the laser irradiation.

The light irradiation for fabricating the polycrystal type silicon film can be conducted concurrent with the light irradiation used in fabrication of the coating film using the present inventive composition.

For the fabrication of the silicon oxide film, the coating film comprising the present inventive composition is subjected to the heating and/or the light irradiation in the presence of oxygen and/or ozone, for example, air.

The heating is performed by using appropriate heating means including hot plate, oven, and the like preferably at 100 to 800°C, more preferably, at 200 to 600°C and, most preferably, at 300 to 500°C for 1 to 300 minutes, more preferably, 5 to 120 minutes and, most preferably, 10 to 60 minutes.

The oxidation may be insufficient if the temperature is less than 100°C, while the coating film may have undesirable cracks after oxidation in case of the temperature more than 800°C. Likewise, the oxidation may be insufficient when the heating period is less than 1 minute, while the heating for a long period of time more than 300 minutes is needless.

The silicon film and silicon oxide film fabricated according to the present invention can contain impurities such as carbon in a desired range of content thereof with no obstruction to purposes of the present invention, other than the silicon oxide.

The silicon film and silicon oxide film according to the present invention have a film thickness preferably ranging from 0.005 to 20 µm and, more preferably, ranging from 0.01 to 10 µm.

By fabricating a plurality of composite thin films according to the present invention, the film thickness of each of the silicon film and the silicon oxide film can be further increased. For example, the silicon oxide film with the thickness of about 1mm can be obtained.

The substrate used to fabricate the silicon oxide film is not particularly limited and includes a flat substrate or a non-flat substrate having uneven widths as the substrate having the coating film, without limitation of shapes of the substrate. The substrate is preferably made of specific materials that can endure the heating temperature when the polysilane compound coating film is oxidized by the heating.

Illustrative examples of such substrate materials include glass, metal, plastics, ceramics and so on. The glass is selected from, for example, quartz glass, borosilicate glass, soda glass, lead glass, lanthanum glass and the like. The metal material is selected from, for example, gold, silver, copper, nickel, silicon, aluminum, iron and, additionally, stainless steel. The plastic material is selected from, for example, polyimide, polyethersulfone, norbornene based open ring polymers and hydrogenated compounds thereof. The shape of the substrate is not particularly limited, but, includes the forms of agglomerate, plate, film and so on.

According to the present invention, the silicon and/or silicon oxide film is obtainable as described above. More particularly, the compact silicon and/or silicon oxide film is fabricated regardless of areas or shapes of the substrate and appropriately used to manufacture devices requiring high reliability. The present inventive process is economically advantageous since no expensive installations such as vacuum equipments are needed.

For the light irradiation to convert the coating film into the silicon and/or silicon oxide film, the silicon and/or silicon oxide film with desirable patterns can be fabricated by selectively light irradiating a part of the coating film by using a photo-mask having the desired patterns.

In the application(coating) process described above, the liquid silane composition is modified into the amorphous silicon to form the composite thin film which comprises the nanocrystalline silicon dispersed in the amorphous silicon based medium.

As the fabricated composite thin film is apt to have a number of defects, the thin film is treated by oxygenation to passivate the defects expected to exist in the film, especially, on an interface between the amorphous silicon and the crystalline silicon. The oxygenation method is possibly embodied in varied manners according to those skilled in the related art and the present invention preferably uses an oxygen plasma treatment.

Hereinafter, a process for manufacturing the solar cell with use of the composite thin film fabricated by the above process according to the present invention will be described in more detail below.

First, a first process of manufacturing the solar cell is described as follows:
The first process of manufacturing the solar cell with a structure in which at least two semiconductor films with different concentrations and/or species of impurities are laminated between a pair of electrodes, is characterized in that at least one of the semiconductor films is formed of the composite thin film according to the present invention.

Fig. 5 illustrates the solar cell with a lamination structure having at least one semiconductor film formed of the composite thin film which comprises the amorphous silicon and the nanocrystalline silicon according to one embodiment of the present invention.

As shown in Fig. 5, a transparent conductive oxide layer 501 is laminated on a substrate 500; p-type, i-type and n-type semiconductor films 502, 503 and 504 are formed on the conductive oxide layer, respectively; and a metal electrode 505 is disposed on the semiconductor films. The amorphous/nanocrystalline silicon based composite thin film according to the embodiment of the present invention is used as at least one of the p-, i-and n-type semiconductor films.

The conversion efficiency of each of the semiconductor films can be controlled depending on content ratios of the amorphous silicon and the nanocrystalline silicon for fabricating the composite thin film.

According to the present invention, the composite thin film is coated on the substrate 500, then, heat and/or light treated to form a semiconductor film.

Illustrative examples of the substrate materials include glass, metal, plastics, ceramics and so on. The glass is selected from, for example, quartz glass, borosilicate glass, soda glass, lead glass, lanthanum glass and the like. The metal material is selected from, for example, gold, silver, copper, nickel, silicon, aluminum, iron, tungsten and, additionally, stainless steel.

The glass substrate or the plastic substrate having the conductive metal oxide film based on the conductive metal or ITO, etc applied thereon is preferably used.

The plastic material is selected from, for example, polyimide, polyethersulfone, norbornene based open ring polymers, and hydrogenated compounds thereof.

The shape of the substrate is not particularly limited, but, includes the forms of agglomerate, plate, film and so on. A face to be the coating film is a flat and/or a non-flat surface having uneven widths. In case of adopting a heating process in order to convert the coating film into the semiconductor film, the substrate preferably endures heat during the heating process.

When the composite thin film is coated on the substrate, the substrate has the thickness preferably ranging from 0.005 to 10 µm and, more preferably, ranging from 0.01 to 5 µm by means of appropriate methods including, for example, spray coating, roll coating, curtain coating, spin coating, screen printing, off-set printing, ink-jet method, etc. If the composite thin film contains a solvent, the film thickness is defined as a thickness of the film after removing the solvent from the thin film.

The coating film fabrication process is preferably performed under a non-oxidation atmosphere. Such atmosphere preferably comprises the atmosphere substantially not containing oxidation materials such as oxygen, carbon dioxide and so on and, more preferably, the atmosphere containing any one selected from nitrogen, hydrogen, rare gases and/or combination gases thereof.

The application(coating) process may be conducted together with the light irradiation. Conditions for the light irradiation are substantially the same as those for the light irradiation which is generally conducted in the process to convert the composition-containing coating film into the semiconductor film.

The heating for converting the coating film into the semiconductor film is performed under a non-oxidation atmosphere in the heating temperature preferably at 100 to 1,000°C, more preferably, 200 to 850°C and, most preferably, 300 to 750°C for 1 to 600 minutes, more preferably, 5 to 300 minutes and, most preferably, 10 to 150 minutes.

In general, the amorphous silicon film is obtained at the final temperature of about 550°C or less while the polycrystal form silicon film is produced at the temperature more than 550°C. If the final temperature is less than 300°C, thermal decomposition of the polysilane compound is insufficient and may fail to fabricate the silicon film with a desired thickness.

The non-oxidation atmosphere is generally formed by heating in argon atmosphere or hydrogen-containing argon atmosphere.

The light treatment (that is the light irradiation) for converting the coating film into the semiconductor film uses the light source which is selected from: visible light, UV, far-UV, low pressure or high pressure mercury lamps, deuterium lamp and/or streamer of rare gas such as argon Ar, krypton Kr, xenon Xe or so on; and, additionally, YAG laser; argon laser; carbon dioxide laser; excimer laser such as XeF, XeCl, XeBr, KrF, KrCl, ArF or ArCl. Such light source is preferably one with an output power of 10 to 5,000W. More preferably, the output power ranges from 100 to 1,000W. The light source has a wavelength of preferably 170 to 600nm but is not limited thereto, so far as the polysilane compound contained in the composition or the coating film can absorb the light even a little at the wavelength.

Temperature for the light irradiation is preferably in the range of room temperature to 300°C. The light irradiation period ranges from 0.1 to 30 minutes. The light irradiation is preferably performed under the non-oxidation atmosphere, the same as the coating film fabrication process.

The semiconductor film fabricated according to the present invention could be an i-type semiconductor film and, the i-type semiconductor film can be converted into a p-type semiconductor film by doping boron atoms on the i-type semiconductor film. On the other hand, a n-type semiconductor film is formed by doping at least one species of atoms selected from arsenic, phosphorous and antimony on the i-type semiconductor film.

The said p-type or n-type semiconductor film may contain increased amounts of impurities by doping at least one species of atoms selected from boron, arsenic, phosphorous and antimony to the semiconductor film.

Differences of respective components are caused by kinds of materials used to prepare the liquid silicon precursor. Different composite thin films of the present invention correspond to the different liquid silicon precursors.

The doping process adopts any known heat diffusion or ion implantation methods and, as described above, is performed by coating the present inventive composition containing the liquid silicon precursor and the nanocrystalline silicon, which is for fabricating one of other composite thin films, to the semiconductor film, then, heating the coated semiconductor film.

Herein, the semiconductor film made from another composite thin film according to the present invention is the p-type semiconductor film containing boron impurities or the n-type semiconductor film containing at least one selected from arsenic compound, phosphorous compound and antimony compound as the impurities.

Conditions for the heating to form the semiconductor film may be the same as described above.

If the semiconductor film formed as described above is amorphous, the semiconductor film may be treated by high energy light such as the excimer laser to be converted into a polycrystal semiconductor film.

The atmosphere for the light irradiation is preferably the non-oxidation atmosphere the same as the application or printing processes of the composition for the composite thin film.

The solar cell manufactured by the present invention has a structure in that at least two semiconductor films with different concentrations and/or species of impurities are laminated between a pair of electrodes, and which has semiconductor contacts such as pn, pin, ip, in, etc. The solar cell may have semiconductor-metal Schottky type contacts. Metal of the contacts comprises gold, silver, copper, aluminum, titanium, etc. Such semiconductor film is selected from n-type, i-type and p-type layers. The solar cell manufactured by the present invention has at least one of the semiconductor films in the laminate form formed by the above method. Alternatively, all of the laminated semiconductor films may be formed by the above method.

All of the laminated semiconductor films may be amorphous, polycrystal or combination thereof.

The solar cell manufactured by the first process according to the present invention has electrodes, a conductive film for wiring and, optionally, an insulating film besides the semiconductor films but, is not particularly limited thereto. For example, the solar cell generally includes a metal film, a transparent conductive film such as ITO, and an insulating film such as SiO₂. The fabrication process of the constitutional elements may include, for example, normal deposition, sputtering, CVD, etc. and, additionally, use liquid materials not requiring alternative vacuum processing.

The method of forming the conductive film from the liquid materials includes, for example: method of using a suspension prepared by dispersing metal particles in an organic solvent; plating method; a method of forming ITO thin film by coating an organic compound based on indium and tin on a substrate and heating the coated substrate, and the like.

Furthermore, the method of forming the insulating film from the liquid materials includes, for example: a method of fabricating the coating film which comprises the composition to fabricate the above semiconductor film by the heating and/or the light irradiation in the presence of oxygen and/or ozone, for example, air; and a method of fabricating the coating film by coating polysilazane on a substrate and heating the coated substrate to be converted into SiO₂.

For the process of manufacturing the solar cell according to the present invention, the silicon film, the conductive film and the insulating film may be sometimes patterned after film formation, then, used. For this purpose, an ink-jet process may be employed for application of the liquid material concurrent with the patterning, in addition to general processes such as masking, lithography, etc.

Further, the second process of manufacturing the solar cell is described as follows:
The second process uses another composite thin film of the present invention.

The second process of manufacturing the solar cell with a structure in which at least two semiconductor films with different concentrations and/or species of impurities are laminated between a pair of electrodes, is characterized in that at least one of the semiconductor films is formed of another composite thin film according to the present invention.

The semiconductor film formed by the second process is the p-type semiconductor film comprising boron compounds as the impurities, or the n-type semiconductor film comprising at least one of arsenic compounds, phosphorus compounds and antimony compounds.

The solar cell can be manufactured, which has a plurality of various type semiconductor films formed through continuous lamination of the composite thin films fabricated by coating the composition comprising the liquid silicon precursor and the nanocrystalline silicon particles dispersed therein on the substrate or printing the substrate with the composition, and heating the coated or printed substrate.

The p-type or n-type semiconductor film is formed with various types of semiconductors through the doping process to dope at least one species of atoms selected from boron, arsenic, phosphorous and antimony, and the concentration of impurities in the semiconductor film can be increased by the doping process.

Other explanations for the second process of manufacturing the solar cell which are not enclosed herewith, are substantially the same as those for the first process or modified and/or altered within an extent clearly understood by those skilled in the related art.

While the present invention has been described with reference to the preferred embodiment and example, it will be understood by those skilled in the art that various modifications and variations may be made therein without departing from the scope of the present invention as defined by the appended claims.

## Claims

1. A solar cell comprising at least one of composite thin films, each of which comprises a combination of amorphous silicon and crystalline silicon.

2. The solar cell according to claim 1, wherein the composite thin film comprises crystalline silicon particles dispersed in a the amorphous silicon matrix.

3. A solar cell comprising at least one photoelectric conversion layer between a rear electrode and a front electrode, which includes a composite thin film comprising a amorphous silicon matrix and crystalline silicon particles dispersed in the matrix.

4. The solar cell according to any one of claims 1 to 3, wherein the crystalline silicon particles is nano-sized crystals.

5. The solar cell according to claim 4, wherein the size of the nano-sized crystals is 1nm to 500nm.

6. The solar cell according to claim 1 or 3, wherein the amorphous silicon is modified from a liquid silicon precursor.

7. The method according to claim 1 or 3, wherein the amorphous silicon is modified from at least one selected from a group consisting of silane SiH₄, disilane Si₂H₆, cyclopentasilane Si₅H₁₀ and cyclohexasilane Si₆H₁₂.

8. The solar cell according to claim 1 or 3, wherein the composite thin film includes 0 to 10% of dispersant residue.

9. A composition for composite thin film used in a solar cell, comprising 10% to 90% by weight of a liquid silicon precursor and 10% to 90% by weight of crystalline silicon particles dispersed in the liquid silicon precursor.

10. The composition according to claim 9, wherein the liquid silicon precursor is at least one selected from a group consisting of silane SiH₄, disilane Si₂H₆, cyclopentasilane Si₅H₁₀ and cyclohexasilane Si₆H₁₂.

11. The composition according to claim 9, wherein the composition further comprises 0 to 10% of dispersant residue.

12. The composition according to claim 9, wherein the crystalline silicon particles are nanocrystalline silicon particles with a particle size ranging from 1nm to 500nm.

13. A method for manufacturing a solar cell, comprising the steps of:
mixing a liquid silicon precursor with crystalline silicon;
coating the mixture on a substrate or an electrode layer or printing the substrate or the electrode with the mixture; and
heating the coated or printed substrate in order to modify the liquid silicon precursor into an amorphous silicon matrix.

14. The method according to claim 13, wherein the crystalline silicon is nanocrystalline silicon particles with a particle size ranging from 1nm to 500nm.

15. The method according to claim 13, wherein the liquid silicon precursor is at least one selected from a group consisting of silane SiH₄, disilane Si₂H₆, cyclopentasilane Si₅H₁₀ and cyclohexasilane Si₆H₁₂.

16. The method according to claim 13, further comprising a passivation step of removing defects on an interface between the amorphous silicon and the crystalline silicon with a passivation gas after the heating step.

17. The method according to claim 16, wherein gas for the passivation is at least one selected from a group consisting of oxygen, ozone containing oxygen, oxygen plasma gas, mixture gas of the aforementioned three gases, hydrogen, hydrogen fluoride, hydrogen bromide, and phosphine.

18. The process according to claim 13, wherein the mixture further comprises a dispersant and/or a surfactant.

19. The process according to claim 13, wherein the heating temperature is in range of 300°C to 500°C.
